Europäisches Patentamt

European Patent Office

Office européen des brevets

(11) Veröffentlichungsnummer: **0 071 594**
**A1**

(12) **EUROPÄISCHE PATENTANMELDUNG**

(21) Anmeldenummer: 82890052.2

(22) Anmeldetag: 09.04.82

(51) Int. Cl.³: **H 03 G 3/00**
**H 03 G 1/04**

(30) Priorität: 26.05.81 AT 2352/81

(43) Veröffentlichungstag der Anmeldung:
09.02.83 Patentblatt 83/6

(84) Benannte Vertragsstaaten:
CH DE FR GB LI

(71) Anmelder: SIEMENS AKTIENGESELLSCHAFT
ÖSTERREICH
Apostelgasse 12
A-1030 Wien(AT)

(72) Erfinder: Kraker, Alfred
Kollergasse 17
A-1030 Wien(AT)

(54) Stelleinrichtung zur Aussteuerung von Tonsignalen.

(57) Zur Herstellung von Orchester-Tonaufzeichnungen werden zuerst Teilaufzeichnungen einzelner Instrumente oder Instrumentgruppen auf ein Vielspurband (T1-3) aufgezeichnet, die dann in weiteren Arbeitsgängen unter laufender Intensitätsregelung durch den Tonmeister entsprechend seinem künstlerischen Empfinden zu einer einzigen Tonspur gemischt werden. Hierzu ist zur Intensitäts- bzw. Dämpfungseinstellung für jede Tonaufzeichnung je eine Stelleinrichtung (ST1-3) vorgesehen, die vom Tonmeister während der Mischung stetig stufenlos betätigt wird. Zur Speicherung der den Tonspuren zugeordneten Intensitätseinstellungen werden den Stelleinrichtungen Matrizenspeicher (MS) zugeordnet, in denen während der Eingabephase die Stellsignale in codierter Form assoziiert mit ebenfalls codierten Zeitsignalen gespeichert werden. Beim Abspielen wird der Original-Tonaufzeichnung unter gleichzeitiger Abrufung des als Zeitfunktion gespeicherten Stellsignales mit Hilfe der Stelleinrichtung die zugehörige Intensitätsaufzeichnung aufgeprägt.

Zufolge der periodischen Abtastung des Zeitsignales und zufolge der Analog-Digitalumsetzung (ADW) können störende Quantisierungsfehler auftreten, die gemäß der Erfindung durch eine mit der Analog-Digital-Umsetzung verbundene Umsetzung des Stellsignalwertes gemäß einer pseudologarithmischen Kennlinie (FW1) vor der Einspeicherung in den Matrixspeicher (MS) vermieden werden. Beim Abrufen des gespeicherten Stellsignales erfolgt die Rückumsetzung gemäß der inversen Kennlinie (FW2) zusammen mit der Digital-Analog-Rückumsetzung (DAW).

FIG.2

- 1 -

## Stelleinrichtung zur Aussteuerung von Tonsignalen

Gegenstand der Erfindung ist eine Stelleinrichtung zur Aussteuerung von Tonsignalen mit Hilfe eines Dämpfungs-Stellsignales, das in kontinuierlich mit der Hand betätigbaren Dämpfungs-Stelleinrichtungen (Potentiometer) erzeugt und nach Analog-Digital-Umsetzung in ein in codierter Form speicherbares Digitalsignal übergeführt wird, aus dem durch Digital-Analog-Rückumsetzung ein das Tonsignal bedämpfendes analoges Steuersignal gewonnen wird, insbesondere zur nachträglichen Bearbeitung von Vielspur-Tonaufzeichnungen, derart, daß jedem Digitalsignalwert ein Stellwegabschnitt an der Dämpfungs-Stelleinrichtung zugeordnet ist.

Zur Herstellung von Orchester-Tonaufzeichnungen werden üblicherweise zuerst Vielspur-Tonaufzeichnungen auf einem Vielspurtonband von einzelnen Instrumenten oder Instrumentengruppen, denen je ein Mikrofon zugeordnet worden ist, gemacht. Sodann werden in einem zweiten Arbeitsgang oder auch in mehreren aufeinanderfolgenden Arbeitsgängen unter gleichzeitiger künstlerischer Nachbearbeitung, d.h. mit dem Empfinden des Tonmeisters entsprechenden Intensitäten, z.B. Dämpfungswerten mehrere Tonaufzeichnungen zu einer einzigen gemischt. Zur Intensitäts- bzw. Dämpfungseinstellung ist für jede einzelne Tonaufzeichnung je eine Stelleinrichtung vorgesehen, die vom Tonmeister fortlaufend stufenlos betätigt wird und die jeweils ein entsprechendes Stellsignal an einen in den betreffenden Tonsignalübertragungsweg eingeschalteten Verstärker oder Dämpfungssteller abgibt.

Im allgemeinen werden Orchester-Tonaufzeichnungen in der Weise hergestellt, daß zuerst jeweils mehrere Einzelaufzeichnungen zu Gruppenaufzeichnungen zusammengefaßt werden, die dann in einem zweiten Arbeitsgang zur Gesamtaufzeichnung verarbeitet werden. Bei der Herstellung der Gruppenaufzeichnungen werden die Stellsignale für die Einzelaufzeichnungen untereinander in die den künstlerischen Erfordernissen erforderlichen Relationen gebracht, die dann aufgezeichnet und zur Bildung der Gesamtaufzeichnung, bei der dann die Gruppenaufzeichnungen in entsprechende Relationen zueinander gebracht werden, beibehalten werden. Dieses Verfahren erfordert jedoch eine Einspeicherung der Stellsignale aller Tonaufzeichnungen als Zeitfunktionen. Zu diesem Zweck werden den Stelleinrichtungen Matrizenspeicher zugeordnet, in denen während der Eingabephase die Stellsignale in codierter Form assoziiert mit ebenfalls codierten Zeitsignalen gespeichert werden, derart, daß während der Ausgabephase bei Eingabe eines bestimmten Zeitsignales das zugehörige Stellsignal ausgegeben wird. Somit kann bei jedmaligem Abspielen einer Original-Tonaufzeichnung unter gleichzeitiger Abrufung des als Zeitfunktion gespeicherten Stellsignales mit Hilfe der Stelleinrichtung die zugehörige Intensitäts- bzw. Dämpfungseinstellung der Original-Tonaufzeichnung aufgeprägt werden.

Die Umwandlung der vom Tonmeister gegebenen analogen Stellgröße, die meist in Form einer Spannung abgebildet wird, in die speicherbare Digitalgröße erfolgt durch periodische Abtastung, z.B. mit einer Frequenz von 32 Hz. Hierbei kann der Fall eintreten, daß die Stellgröße auf einen solchen Analogwert eingestellt wird, dessen entsprechende Digitalgröße gerade zwischen zwei benachbarten Werten liegt, wobei der Analog-Digitalwandler abwechselnd einmal den einen und dann den anderen dieser Werte abbildet, wodurch dem Ausgangssignal, dessen Verstärkung bzw. Dämpfung zwischen diesen beiden Werten mit der Abtastfrequenz schwankt, ein störender Quantisierungsfehler überlagert wird.

Fehler dieser Art hält die Erfindung unterhalb störender Werte dadurch, daß in den Stellsignal-Übertragungsweg zusammen mit der Analog-Digital-Umsetzung auch eine Umsetzung gemäß einer pseudologarithmischen Kennlinie vorgesehen ist, die durch eine nachfolgende Digital-Analog-Rückumsetzung gemäß der inversen Kennlinie in Bezug auf das zur Aussteuerung herangezogene Steuersignal aufgehoben ist, derart, daß sich die auf einen Digitalsignalwert entfallenden Stellwegabschnitte mit wachsender Bedämpfung (d.h. mit verringernder Tonsignalamplitude) vergrößern. Dies ergibt sich daraus, daß die Steigung einer logarithmischen Kurve bei zunehmendem Argument im Ausmaß des Reziprokwertes des Argumentes abnimmt.

Fig. 1 der Zeichnung zeigt die prinzipielle Anordnung von Stelleinrichtungen zur Aussteuerung von Tonsignalen einer Vielspur-Tonaufzeichnung, während in

Fig. 2 ein Ausführungsbeispiel der Erfindung dargestellt ist.

Fig. 3 zeigt ein Diagramm zur Erläuterung der Wirkungsweise der Erfindung.

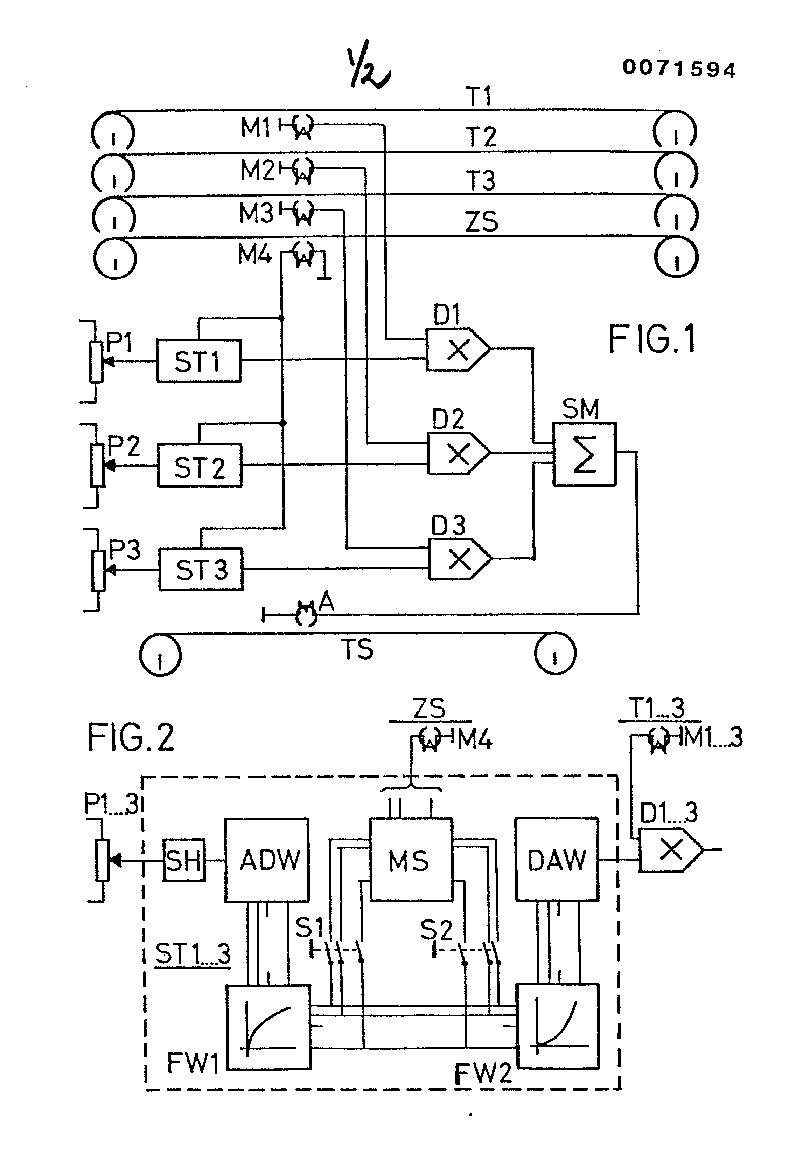

In Fig. 1 sind mit T1, T2 und T3 drei Tonspuren einer Vielspur-Tonaufzeichnung (mit z.B. insgesamt 16.Tonspuren) bezeichnet, auf denen je eine Aufnahme von Instrumenten oder Instrumentengruppen aufgezeichnet ist. Eine vierte, mit ZS bezeichnete Spur enthält in codierter Form Zeitmarken, die z.B. in Abständen von 1/32 Sekunden die Bandpositionen eindeutig markieren. Die Abtastung der drei Tonspuren erfolgt mittels dreier Magnetköpfe M1, M2 und M3, deren Ausgangssignale über drei Dämpfungssteller D1, D2 und D3 einer Summierschaltung SM zugeführt werden, deren Summen-Ausgangssignal mittels eines Aufspielkopfes A einer weiteren Tonspur TS aufgeprägt wird. Zur Einstellung der Dämpfungsgrade der Dämpfungssteller D1, D2 bzw. D3 dienen Steuersignale, die von zugeordneten

- 4 -

Dämpfungs-Stelleinrichtungen ST1, ST2 bzw. ST3 geliefert werden und die mittels zugeordneter Potentiometer P1, P2 bzw. P3 vom Tonmeister während der Mischung der Signale von zwei oder von allen drei Tonspuren laufend eingestellt werden.

Den mit strichlierten Linien umrandeten inneren Aufbau einer der drei Stelleinrichtungen ST1... zeigt Fig. 2. Die jeweilige Stellung des Potentiometers P1 ... P3 wird von einer Sample-Hold-Schaltung SH jeweils für die Dauer einer Abtastphase festgehalten. Das Ausgangssignal der Sample-Hold-Schaltung SH wird mittels eines Analog-Digital-Wandlers ADW in ein Digitalsignal umgewandelt, das einem Funktionswandler FW 1 mit pseudologarithmischer Kennlinie zugeführt wird. Das digitale Ausgangssignal des Funktionswandlers FW 1 gelangt einerseits an den Eingang eines zweiten Funktionswandlers FW2 mit inverser pseudologarithmischer Kennlinie, der also mit seinem Ausgangssignal die originale Stellgröße wieder abbildet. Anderseits sind an den den Ausgang des Funktionswandlers FW 1 mit dem Eingang des Funktionswandlers FW 2 verbindenen Datenbus sowohl der Dateneingang eines Matrizenspeichers MS über einen Schalter S 1 als auch dessen Datenausgang über einen weiteren Schalter S2 anschließbar. Der Matrizenspeicher MS besitzt einen Adresseneingang, dem die codierten Zeitmarken als Adressen eingegeben werden. Demgemäß werden die die Stellgröße abbildenden Daten in der gleichen Reihenfolge der Zeitmarken beim Abruf (Schalter S2 geschlossen) ausgegeben, wie sie beim Einspeichern (Schalter S1 geschlossen) eingegeben wurden. Das digitale Ausgangssignal des Funktionswandlers FW 2 wird von einem angeschlossenen Digital-Analog-Wandler DAW in das analoge Steuersignal rückübersetzt, das den Dämpfungsgrad des nachgeschalteten Dämpfungsstellers D1, D2 oder D3 bestimmt.

Die Erfindung macht sich den Umstand zu nutze, daß die Stellgröße wegen der zeitabhängigen Zwischenspeicherung im Matrixspeicher MS notwendigerweise in digital codierte Form umgesetzt und wieder rückgebildet werden

- 5 -

muß und bewirkt durch die pseudologarithmische Verzerrung und nachfolgende Aufhebung der Verzerrung, daß die sich zufolge der digitalen Zwischenumsetzung sprunghaft ändernde Ausgangsgröße des Digital-Analog-Wandlers DAW, die den jeweiligen Dämpfungsgrad bestimmt, im Bereich hoher Aussteuerung (bei großen Amplituden) sprunghafte Änderungen geringerer Höhe durchführt als im Bereich kleiner Amplituden in welchem als Folge von Einstellungen der Potentiometer P1, P2 bzw. P3 in der Nähe des Ausschaltewertes größere Änderungen der Aussteuerung kaum ins Gewicht fallen.

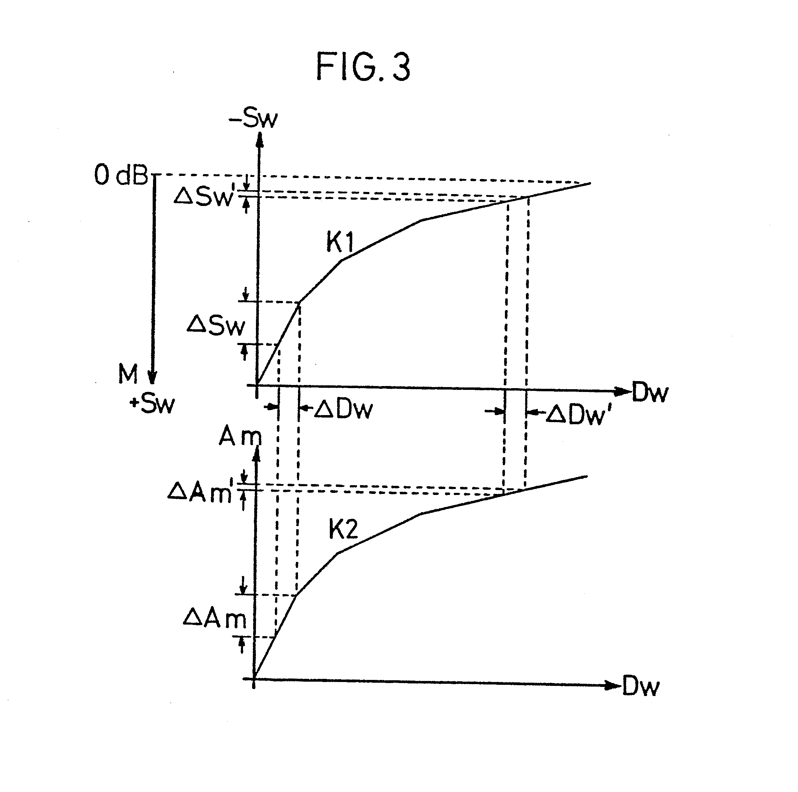

Die Wirkungsweise der erfindungsgemäßen Stelleinrichtung ist im folgenden an Hand des Diagramms der Fig. 3 erläutert: Mit Sw ist der Stellweg des Abgriffes an einem der Potentiometer P1 ... 3 bezeichnet, dessen Skala in dB (Dämpfung) geeicht ist, ausgehend vom Wert O dB (keine Dämpfung) bis zu einem Maximalwert M, bei dem Praktisch jede Übertragung unterbunden ist. Der dem Stellweg zugeordnete dB-Wert Sw wird, wie an Hand der Fig. 2 beschireben, zunächst im Funktionswandler FW 1 gemäß einer pseudologarithmischen Kennlinie, die in Fig. 3 mit K1 bezeichnet ist, umgesetzt und danach im Funktionswandler FW 2 gemäß der inversen Kennlinie K2 rückübersetzt, was durch die spezielle Anordnung der Diagramme in Fig. 3 in der Weise zum Ausdruck gebracht wird, daß der Stellweg Sw in der Ordinatenrichtung der Kennlinie K1 und die jeweilige Maximalamplitude Am des bedämpften Tonsignales in der Ordinatenrichtung der Kennlinie K2 aufgetragen ist. Die übereinstimmenden Abszissenwerte der Kennlinien K1 und K2 entsprechen den jeweils zwischengespeicherten Digitalwerten Dw und sind mit aequidistanter Unterteilung dargestellt. Die pseudologarithmischen Kennlinien K1, K2 sind durch Geradestücke der logarithmischen Funktion angenähert.

Im Diagramm sind zwei gleich große Abszissen-Unterteilunge $\Delta$ Dw, $\Delta$ Dw' herausgegriffen, die jeweils einer Gruppe von mehreren aufeinanderfolgenden Digitalwerten zugeordnet sind und zwar liegt eine ($\Delta$ Dw) dieser Unterteilungen am Anfang und die andere ($\Delta$ Dw') am Ende der Kennlinie. Diesen Unterteilungen entsprechen jedoch zwei unterschiedliche Stellwegdifferenzen $\Delta$ Sw bzw. $\Delta$ Sw' an der Ordinate der Kennlinie K1 sowie

zwei unterschiedliche Maximalamplitudendifferenzen $\Delta$ Am bzw. $\Delta$ Am' an der Ordinate der Kennlinie K2. Aus dem Diagramm ergibt sich unmittelbar, daß in Bereichen geringer Dämpfung, d.h. im Bereich großer Maximalamplituden auf die gleiche Anzahl von Digital-Speicherwerten geringere Stellwegdifferenzen entfallen als in Bereichen großer Dämpfung. Dies hat die bereits erwähnte Reduktion von Quantisierungsstörungen im Bereich großer Amplituden - also im normalen Arbeitsbereich den Potentiometer - zur Folge.

0071594

- 1 -

Patentanspruch:

Stelleinrichtung zur Aussteuerung von Tonsignalen mit Hilfe eines Dämpfungs-Stellsignales, das in kontinuierlich mit der Hand betätigbaren Dämpfungs-Stelleinrichtungen (Potentiometern) erzeugt und nach Analog-Digital-Umsetzung in ein in codierter Form speicherbares Digitalsignal übergeführt wird, aus dem durch Digital-Analog-Rückumsetzung ein das Tonsignal bedämpfendes analoges Steuersignal gewonnen wird, insbesondere zur nachträglichen Bearbeitung von Vielspur-Tonaufzeichnungen, derart, daß jedem Digitalsignalwert ein Stellwegabschnitt an der Dämpfungs-Stelleinrichtung zugeordnet ist, dadurch gekennzeichnet,

daß in den Stellsignal-Übertragungsweg zusammen mit der Analog-Digital-Umsetzung auch eine Umsetzung gemäß einer pseudologarithmischen Kennlinie vorgesehen ist, die durch eine nachfolgende Digital-Analog-Rückumsetzung gemäß der inversen Kennlinie in Bezug auf das zur Aussteuerung herangezogene Steuersignal aufgehoben ist, derart, daß sich die auf einen Digitalsignalwert entfallenden Stellwegabschnitte mit wachsender Bedämpfung (d.h. mit verringernder Tonsignalamplitude) vergrößern.

½  0071594

FIG.1

FIG.2

FIG. 3

Europäisches
Patentamt

## EUROPÄISCHER RECHERCHENBERICHT

EP 82 89 0052

### EINSCHLÄGIGE DOKUMENTE

| Kategorie | Kennzeichnung des Dokuments mit Angabe. soweit erforderlich. der maßgeblichen Teile | Betrifft Anspruch | KLASSIFIKATION DER ANMELDUNG (Int. Cl. ³) |
|---|---|---|---|
| Y | FR-A-2 447 578 (D.ROSSET et al.) *Seite 1, Zeilen 1-5; Seite 2, Zeile 29 - Seite 4, Zeile 34; Figuren* | 1 | H 03 G 3/00 H 03 G 1/04 |
| Y | JOURNAL OF THE AUDIO ENGINEERING SOCIETY, Band 26, Nr. 10, Oktober 1978, Seiten 739-771; B.A.BLESSER: "Digitization of Audio: A comprehensive examination of theory, implementation, and current practice". *Seite 754, Absatz 2.4. und Figur 13* | 1 | |
| A | DE-A-2 926 011 (TOKYO SHIBAURA) *Seite 9, Zeile 9 - Seite 12, Zeile 28; Figur 2* | 1 | |
| A | DE-A-2 058 965 (TOMOGRAPHIE APPARATEBAU V. WILLISEN) *Seite 5, Zeile 26 - Seite 8, Zeile 6; Figuren 1 und 2* | 1 | RECHERCHIERTE SACHGEBIETE (Int. Cl. ³) H 03 G |
| A | DE-A-2 541 477 (SIEMENS) *Seite 4, Zeile 27 - Seite 5, Zeile 15* | 1 | H 04 H 7 |

Der vorliegende Recherchenbericht wurde für alle Patentansprüche erstellt.

| Recherchenort | Abschlußdatum der Recherche | Prüfer |
|---|---|---|
| DEN HAAG | 20-10-1982 | VAN WEEL E.J.G. |